# EUROPEAN PATENT SPECIFICATION

(11) **EP 3 154 098 B1**
(45) Date of publication and mention of the grant of the patent: **14.03.2018**
(21) Application number: 15803369.6
(22) Date of filing: 01.06.2015
(51) Int. Cl.: H01L 35/34, H01L 35/32, H01L 35/08

(54) **METHOD FOR MANUFACTURING THERMOELECTRIC CONVERSION ELEMENT SHEET**
VERFAHREN ZUR HERSTELLUNG FOLIE FÜR THERMOELEKTRISCHES UMWANDLUNGSELEMENT
PROCÉDÉ DE FABRICATION DE FEUILLE D'ÉLÉMENTS DE CONVERSION THERMOÉLECTRIQUE

(30) Priority: 03.06.2014 JP 2014114826; 14.05.2015 JP 2015099315
(43) Date of publication of application: 12.04.2017
(73) Proprietor: DENSO CORPORATION, Kariya-city, Aichi 448-8661 (JP)
(72) Inventor: SHIRAISHI, Yoshihiko, Kariya-city, Aichi-pref., 448-8661 (JP); SAKAIDA, Atusi, Kariya-city, Aichi-pref., 448-8661 (JP); GOUKO, Norio, Kariya-city, Aichi-pref., 448-8661 (JP)
(74) Representative: Kuhnen & Wacker
(86) International application number: PCT/JP2015/002740
(87) International publication number: WO 2015/186328

(56) References cited:
- JP-A- H10 303 472
- JP-A- 2003 023 185
- JP-A- 2005 235 958
- JP-A- 2005 268 284
- JP-A- 2006 165 457
- JP-A- 2007 157 908
- JP-A- 2012 129 303
- JP-A- 2013 195 468
- JP-A- 2014 007 376
- US-A- 6 127 619
- US-A1- 2011 275 165

## Description

### TECHNICAL FIELD

The present disclosure relates to a method for manufacturing a thermoelectric conversion element sheet.

### BACKGROUND ART

There has been proposed a thermoelectric conversion device in which a P-type element and an N-type element are alternately connected in series. As a method for manufacturing such a thermoelectric conversion device, for example, Patent Literature 1 proposes a manufacturing method as follows.

In this manufacturing method, first, an insulating base member is prepared, and first and second via holes are formed in this insulating base member. Then, the first via hole is filled with a first conductive paste, and the second via hole is filled with a second conductive paste. The first conductive paste is a conductive paste containing Bi-Sb-Te alloy powder (metal particles) that constitutes the P-type, and the second conductive paste is a conductive paste containing Bi-Te alloy powder (metal particles) that constitutes the N-type.

Further, a front surface protection member formed with a front surface pattern and a rear surface protection member formed with a rear surface pattern are prepared. Then, the rear surface protection member, the insulating base member, and the front surface protection member are sequentially stacked to form a stacked body such that the first conductive paste and the second conductive paste appropriately come into contact with the front surface pattern and the rear surface pattern.

Thereafter, this stacked body is pressed from both upper and lower surfaces in a stacking direction while being heated, to constitute a P-type element from the first conductive paste and an N-type element from the second conductive paste. Further, the P-type element and the N-type element are appropriately connected with the front surface pattern and the rear surface pattern. Accordingly, a thermoelectric conversion device with the P-type element and the N-type element alternately connected in series is manufactured.

In such a thermoelectric conversion device, the conversion efficiency can be appropriately changed by changing the number of P-type elements and N-type elements, diameters thereof, or the like, for example. Hence in the above manufacturing method, a thermoelectric conversion device with desired conversion efficiency can be manufactured by appropriately changing the number of first and second via holes, diameters of the holes, or the like.

However, the above manufacturing method has a problem where the design has to be changed depending on the intended use, and hence the degree of freedom for design and manufacturing is low.

### PRIOR ART LITERATURES

### PATENT LITERATURE

Patent Literature 1: JP-2014-007409-A

### SUMMARY OF INVENTION

It is an object of the present disclosure to provide a thermoelectric conversion element sheet capable of improving the degree of freedom for design and manufacturing, a method for manufacturing the same, and a method for manufacturing a thermoelectric conversion device.

According to a first aspect of the present disclosure, a thermoelectric conversion element sheet includes: a base material that has a plurality of formation regions; and a plurality of thermoelectric conversion elements respectively disposed in the plurality of formation regions. The thermoelectric conversion elements disposed in adjacent formation regions are electrically connected through a connection pattern for extracting an electrode.

According to the above thermoelectric conversion element sheet, thermoelectric conversion elements are formed in respective formation regions, and each of the thermoelectric conversion elements is connected. Hence a thermoelectric conversion device may be obtained by cutting the thermoelectric conversion element sheet depending on the intended use, and the design of the thermoelectric conversion element sheet itself need not be changed depending on the intended use. It is thus possible to improve the degree of freedom for design and manufacturing.

According to a second aspect of the present disclosure, a thermoelectric conversion element sheet includes: a base material that has a plurality of formation regions; and a plurality of thermoelectric conversion elements respectively disposed in the plurality of formation regions. One direction in a plane direction of the base material is defined as a first direction, and a direction intersecting with the first direction is defined as a second direction. The plurality of thermoelectric conversion elements are respectively arranged along the first direction and the second direction. The thermoelectric conversion elements adjacent to each other along the first direction are electrically connected with each other. Two of the thermoelectric conversion elements adjacent to each other along the second direction provide a pair. The thermoelectric conversion elements in the pair disposed on one end in the first direction are electrically connected with each other. The thermoelectric conversion element in one of two pairs adjacent to each other along the second direction, which are disposed on the other end in the first direction, and the thermoelectric conversion element in the other of two pairs are electrically connected with each other, and the thermoelectric conversion elements are connected in series with each other.

According to the above thermoelectric conversion element sheet, thermoelectric conversion elements are formed in respective formation regions, and each of the thermoelectric conversion elements is connected. Hence a thermoelectric conversion device may be obtained by cutting the thermoelectric conversion element sheet depending on the intended use, and the design of the thermoelectric conversion element sheet itself need not be changed depending on the intended use. It is thus possible to improve the degree of freedom for design and manufacturing.

According to a third aspect of the present disclosure, a thermoelectric conversion element sheet includes: a base material that has a plurality of formation regions; and a plurality of thermoelectric conversion elements respectively disposed in the plurality of formation regions. One direction in a plane direction of the base material is defined as a first direction. The plurality of thermoelectric conversion elements are arranged along the first direction, and electrically connected to each other to be connected in series with each other.

According to the above thermoelectric conversion element sheet, thermoelectric conversion elements are formed in respective formation regions, and each of the thermoelectric conversion elements is connected. Hence a thermoelectric conversion device may be obtained by cutting the thermoelectric conversion element sheet depending on the intended use, and the design of the thermoelectric conversion element sheet itself need not be changed depending on the intended use. It is thus possible to improve the degree of freedom for design and manufacturing.

According to a fourth aspect of the present disclosure, and according to claim 1, a method for manufacturing a thermoelectric conversion element sheet includes: preparing an insulating base member that includes a plurality of formation regions, and has thermoplastic resin in which a plurality of first via holes and a plurality of second via holes penetrating the formation regions in a thickness direction are arranged in each of the plurality of formation regions, and the first via holes and the second via holes are respectively filled with a first conductive paste and a second conductive paste; preparing a front surface protection member having a plurality of front surface patterns spaced apart from each other and a plurality of connection patterns spaced apart from each other, which are arranged on one surface of the front surface protection member; preparing a rear surface protection member having a plurality of rear surface patterns spaced apart from each other, which are arranged on one surface of the rear surface protection member; arranging the front surface protection member on a front surface of the insulating base member to contact the first conductive paste and the second conductive paste with the front surface patterns and the connection patterns, respectively, and arranging the rear surface protection member on a rear surface of the insulating base member to contact the first conductive paste and the second conductive paste with the rear surface patterns, respectively, so as to form a stacked body; and heating and pressing the stacked body in a stacking direction to integrate into one body so that a first interlayer connection member and a second interlayer connection member are formed from the first conductive paste and the second conductive paste in the each of the formation regions; connecting the first interlayer connection member and the second interlayer connection member with the front surface pattern and the rear surface pattern so as to alternately connect the first interlayer connection member and the second interlayer connection member in series with each other so that a thermoelectric conversion element is formed; and electrically connecting adjacent thermoelectric conversion elements through the connection pattern so that thermoelectric conversion elements are connected in series with each other by connecting the adjacent thermoelectric conversion elements formed in a corresponding formation region; and performing an entire characteristic inspection of the thermoelectric conversion elements connected in series with each other after integration of the stacked body, wherein: in the entire characteristic inspection, when the thermoelectric conversion elements connected in series with each other are not normal as a whole, the characteristic inspection is individually performed on each of the thermoelectric conversion elements, and after performance of an individual characteristic inspection, two thermoelectric conversion elements adjacent to the thermoelectric conversion element being not normal are electrically connected through a connection wiring (118) so that other thermoelectric conversion elements except for the thermoelectric conversion element being not normal are electrically connected in series with each other.

According to the above method for manufacturing the thermoelectric conversion element sheet, the step of forming thermoelectric conversion elements in respective formation regions and the step of electrically connecting each of the thermoelectric conversion elements with each other can be performed by the same step, to simplify the manufacturing process.

According to a fifth aspect of the present disclosure, a method for manufacturing a thermoelectric conversion device includes: performing the method for manufacturing the thermoelectric conversion element sheet according to the fourth aspect; and cutting the thermoelectric conversion element sheet. In the cutting of the thermoelectric conversion element sheet, the thermoelectric conversion element sheet is cut so as to divide the connection pattern.

According to the above method for manufacturing the thermoelectric conversion device, since the thermoelectric conversion element sheet is cut such that the connection pattern is divided, the divided connection pattern can be used as it is as an electrode to be electrically connected with an external circuit.

### BRIEF DESCRIPTION OF DRAWINGS

The above and other objects, features and advantages of the present disclosure will become more apparent from the following detailed description made with reference to the accompanying drawings. In the drawings:
[Fig. 1]

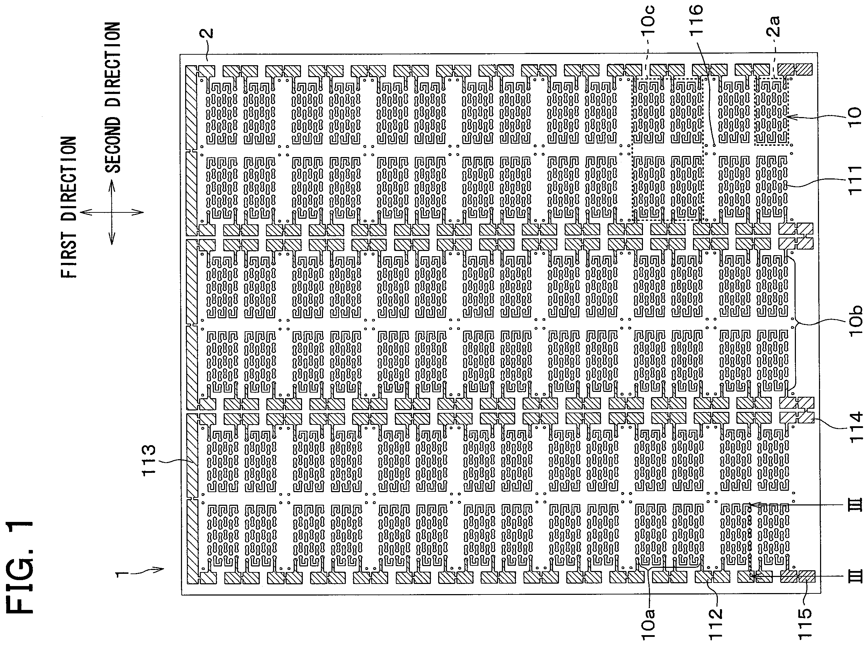

   Fig. 1 is a front surface view showing a thermoelectric conversion element sheet 1 in a first embodiment of the disclosure;
[Fig. 2]

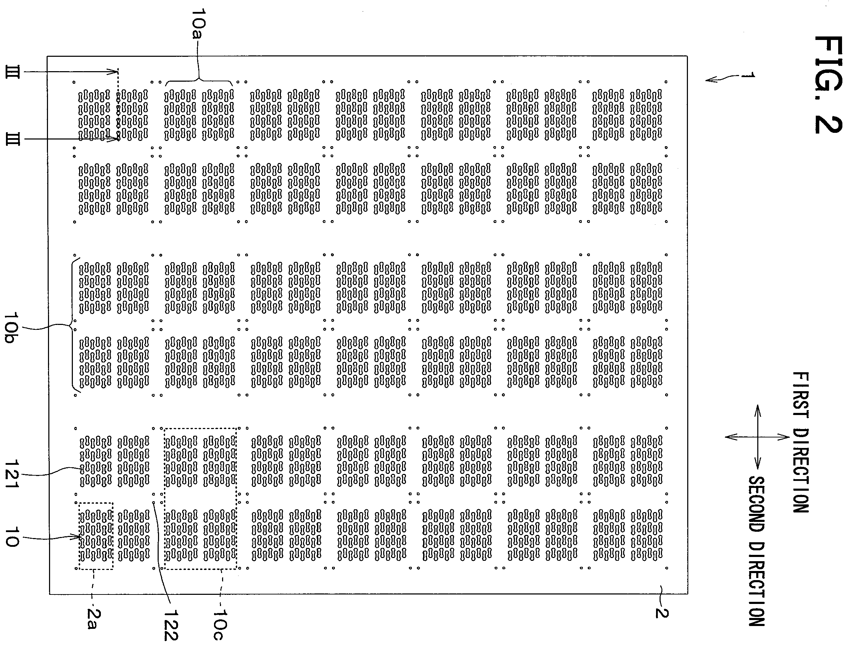

   Fig. 2 is a rear surface view showing the thermoelectric conversion element sheet 1 shown in Fig. 1;
[Fig. 3]

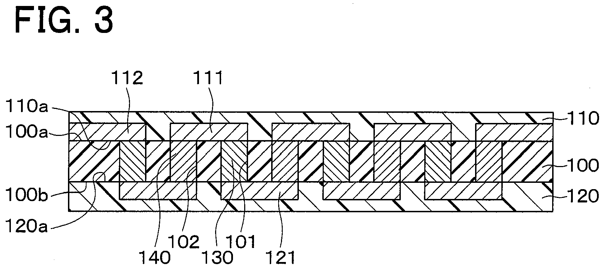

   Fig. 3 is a sectional view showing thermoelectric conversion elements 10 along a line III-III of Figs. 1 and 2;
[Fig. 4]

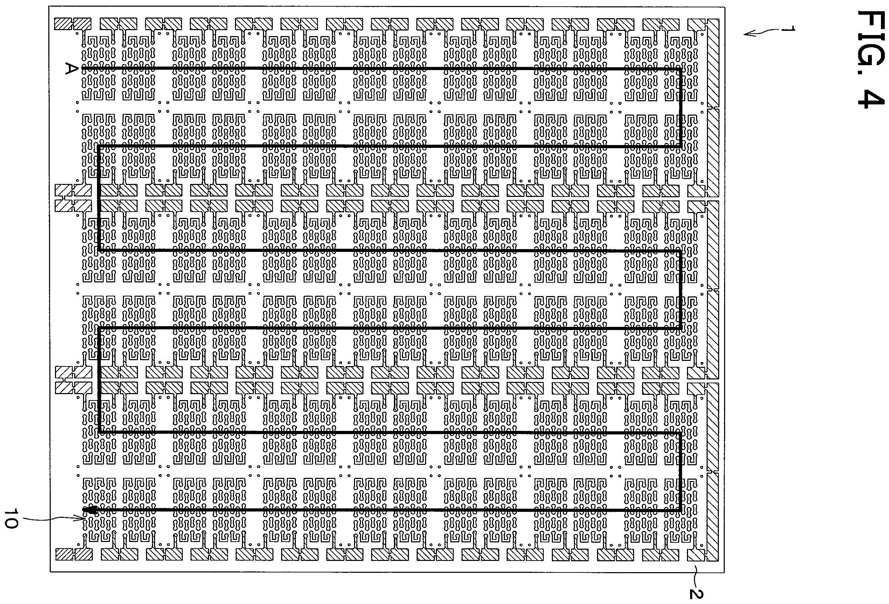

   Fig. 4 is a schematic view showing a connected state of each of the thermoelectric conversion elements 10 in the thermoelectric conversion element sheet 1 shown in Fig. 1;
[Fig. 5]

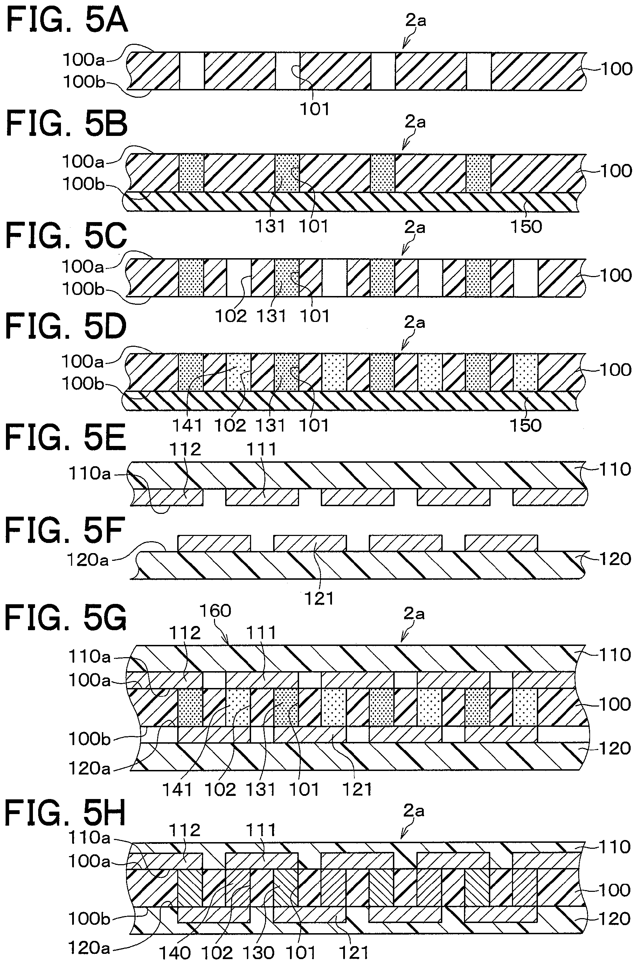

   Figs. 5A to 5H are sectional views showing a manufacturing process of the thermoelectric conversion element sheet 1;
[Fig. 6]

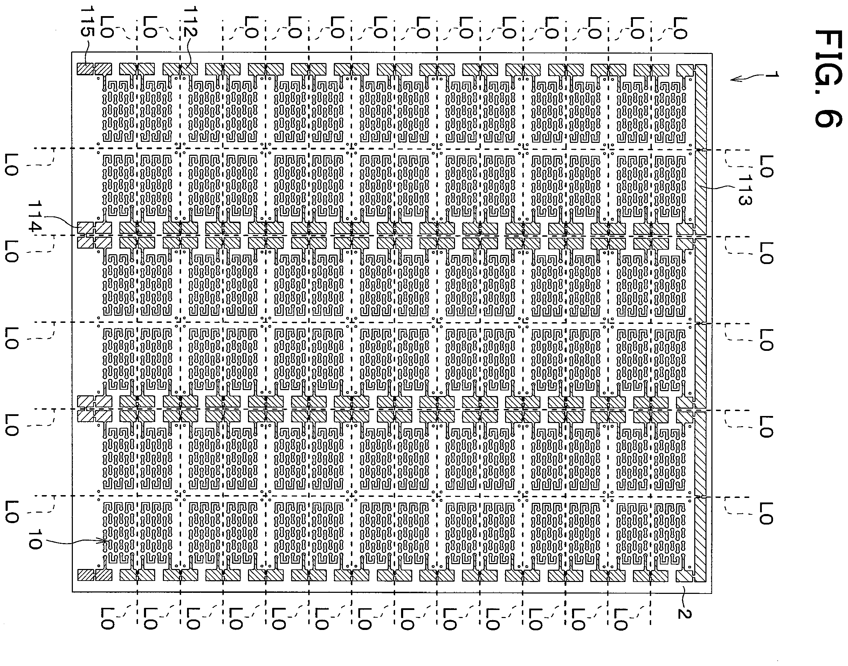

   Fig. 6 is an example of a cutting line L0 of the thermoelectric conversion element sheet 1 shown in Fig. 1;
[Fig. 7]

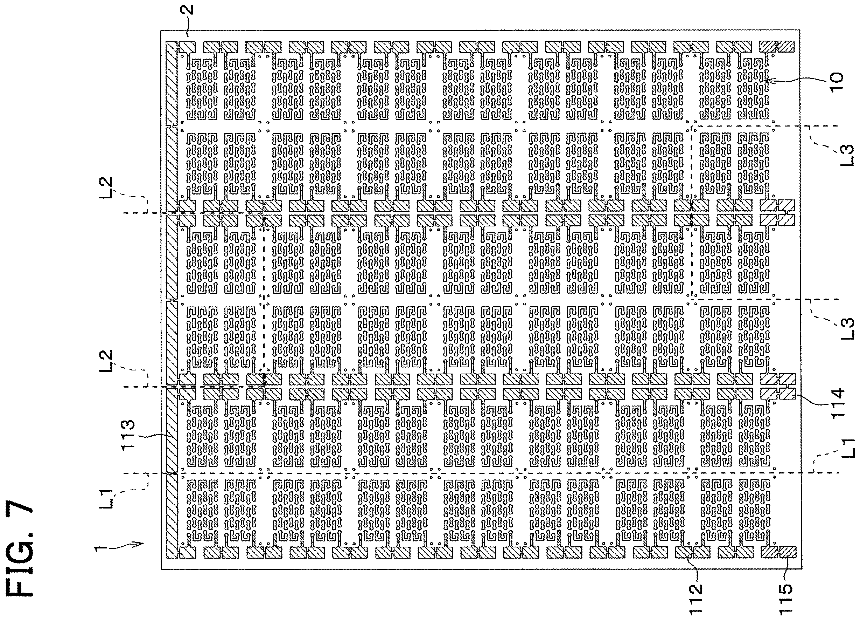

   Fig. 7 is an example of cutting lines L1 to L3 of the thermoelectric conversion element sheet 1 shown in Fig. 1;
[Fig. 8A]

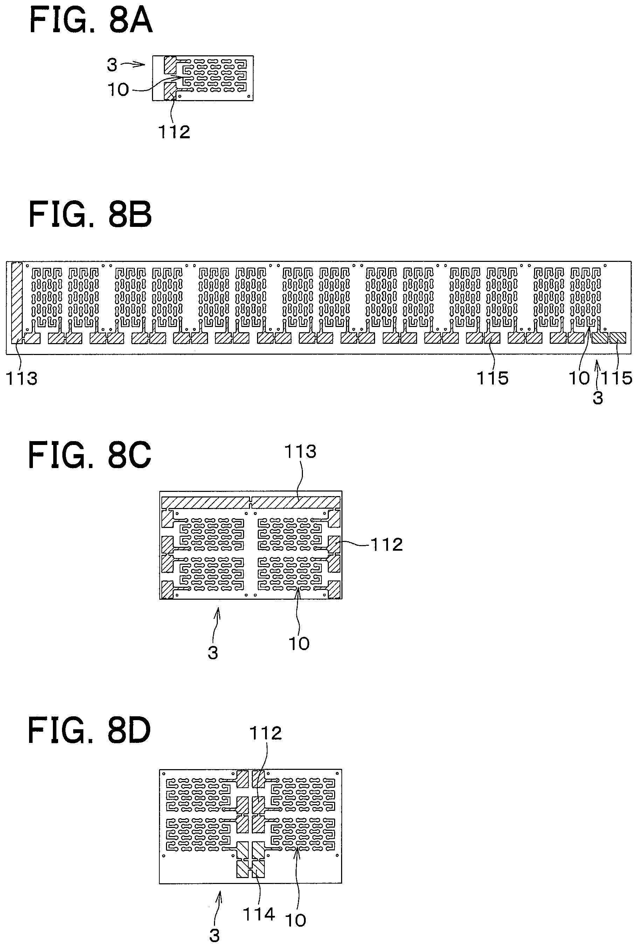

   Fig. 8A is a view showing a thermoelectric conversion device 3 obtained by cutting the thermoelectric conversion element sheet 1 along the cutting line L0 shown in Fig. 6;
[Fig. 8B]
   Fig. 8B is a view showing the thermoelectric conversion device 3 obtained by cutting the thermoelectric conversion element sheet 1 along the cutting line L1 shown in Fig. 7;
[Fig. 8C]
   Fig. 8C is a view showing the thermoelectric conversion device 3 obtained by cutting the thermoelectric conversion element sheet 1 along the cutting line L2 shown in Fig. 7;
[Fig. 8D]
   Fig. 8D is a view showing the thermoelectric conversion device 3 obtained by cutting the thermoelectric conversion element sheet 1 along the cutting line L3 shown in Fig. 7;
[Fig. 9]

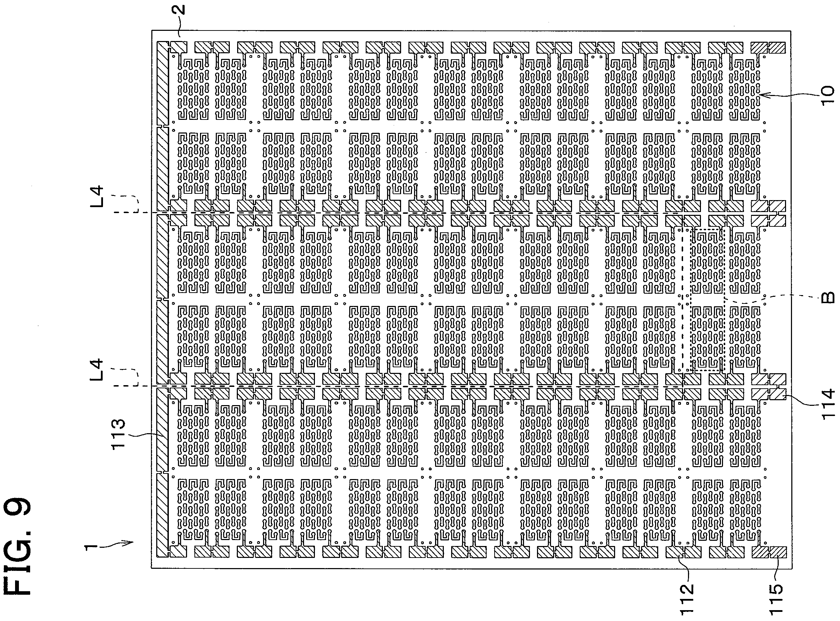

   Fig. 9 is an example of a cutting line L4 of a thermoelectric conversion element sheet 1 in a second embodiment of the present disclosure;
[Fig. 10]

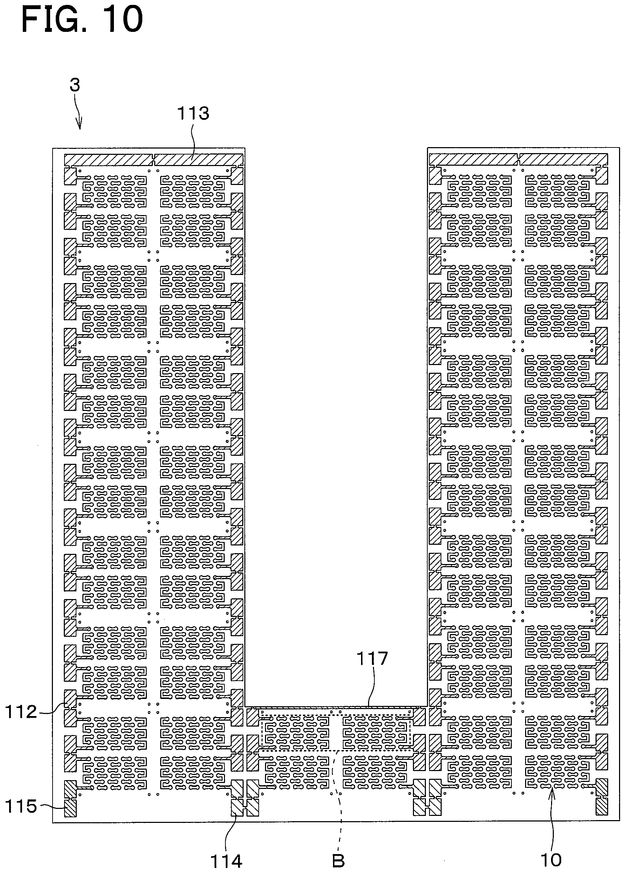

   Fig. 10 is a view showing the thermoelectric conversion device 3 obtained by cutting the thermoelectric conversion element sheet 1 along the cutting line L4 shown in Fig. 9;
[Fig. 11]

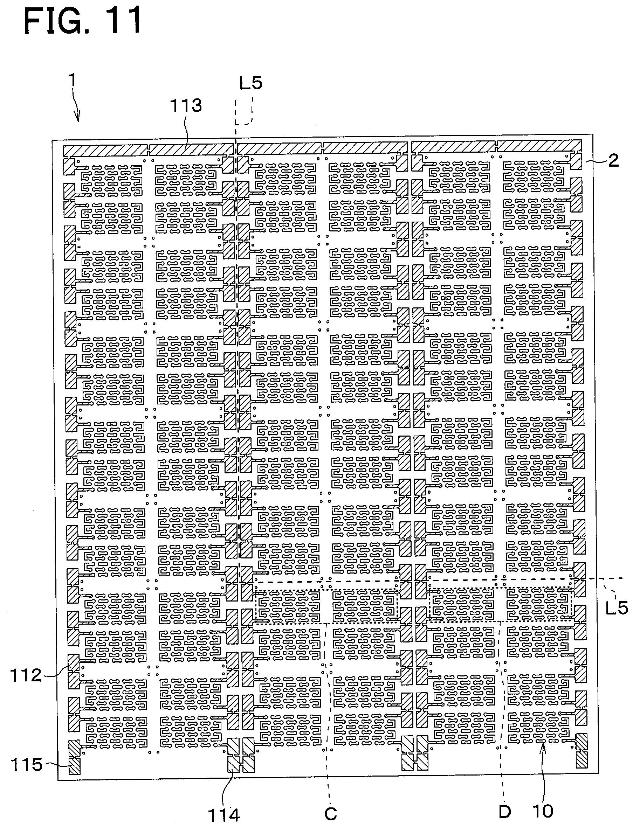

   Fig. 11 is an example of a cutting line L5 of the thermoelectric conversion element sheet 1 in a modified example of the second embodiment of the present disclosure;
[Fig. 12]

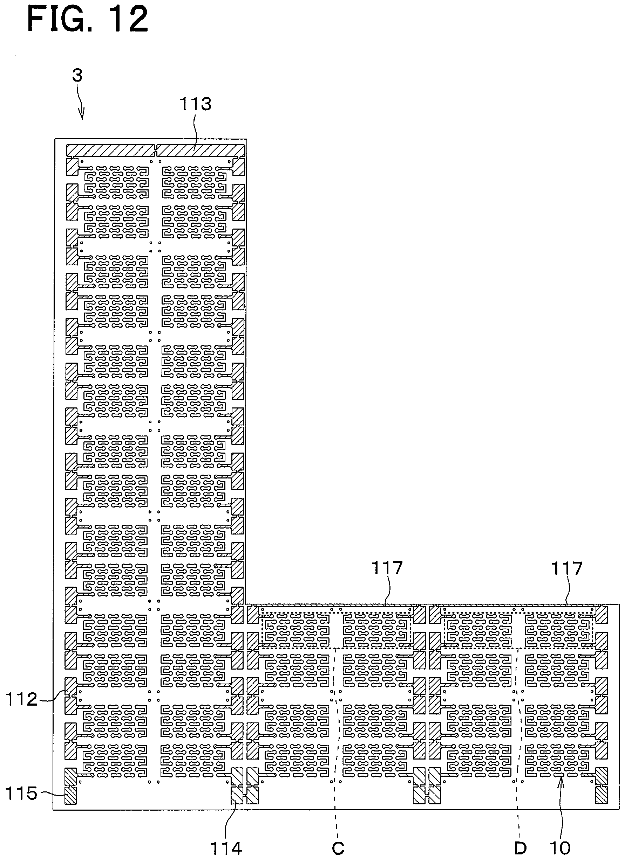

   Fig. 12 is a view showing the thermoelectric conversion device 3 obtained by cutting the thermoelectric conversion element sheet 1 along the cutting line L5 shown in Fig. 11;
[Fig. 13]

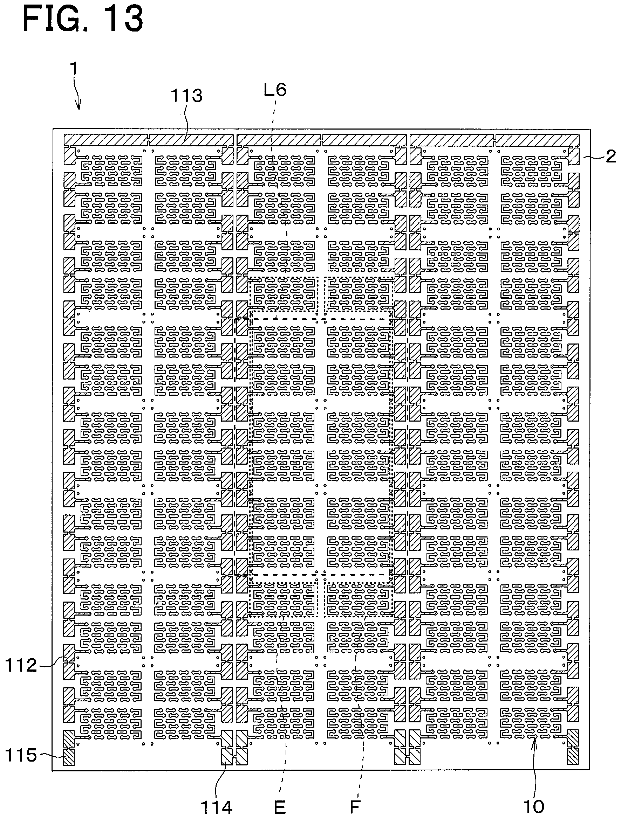

   Fig. 13 is an example of a cutting line L6 of the thermoelectric conversion element sheet 1 in a modified example of the second embodiment of the present disclosure;
[Fig. 14]

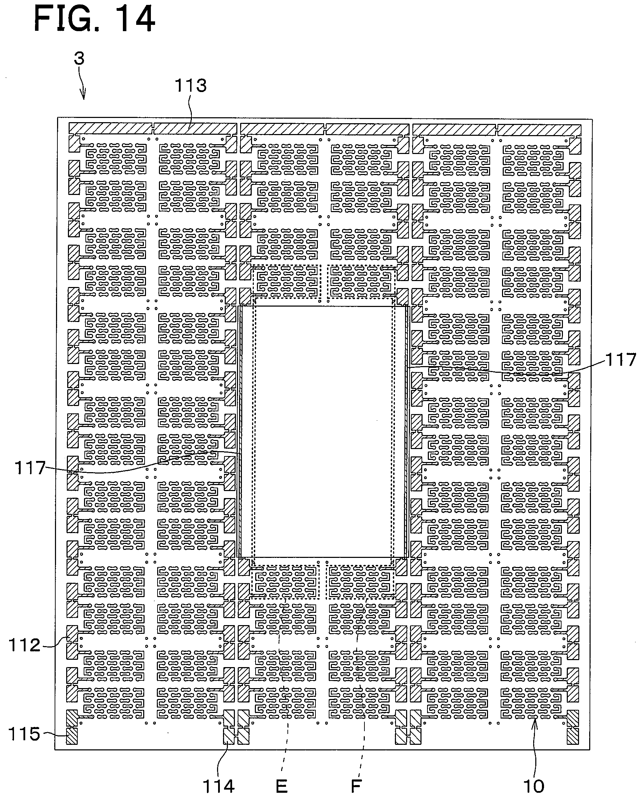

   Fig. 14 is a view showing the thermoelectric conversion device 3 obtained by cutting the thermoelectric conversion element sheet 1 along the cutting line L6 shown in Fig. 13;
[Fig. 15]

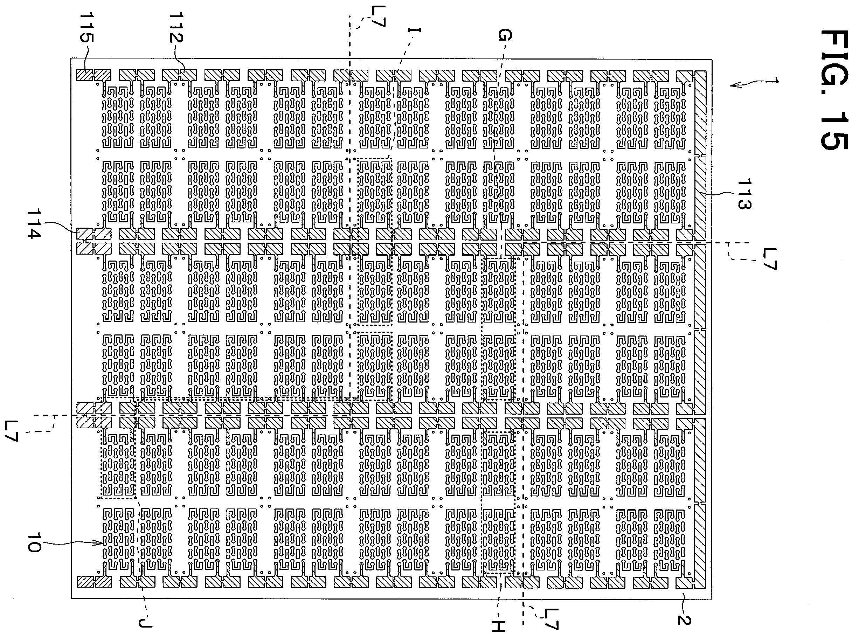

   Fig. 15 is an example of a cutting line L7 of the thermoelectric conversion element sheet 1 in a modified example of the second embodiment of the present disclosure;
[Fig. 16]

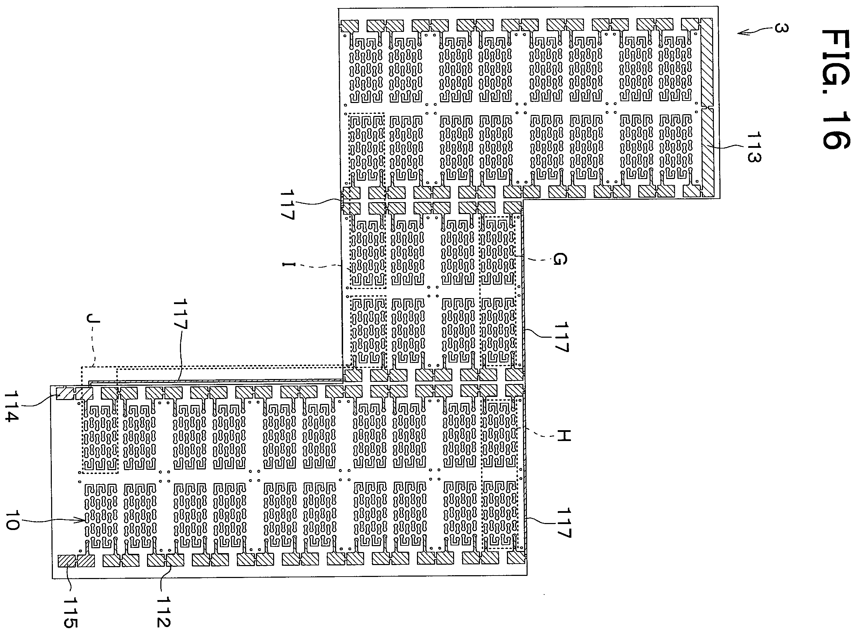

   Fig. 16 is a view showing the thermoelectric conversion device 3 obtained by cutting the thermoelectric conversion element sheet 1 along the cutting line L7 shown in Fig. 15;
[Fig. 17]

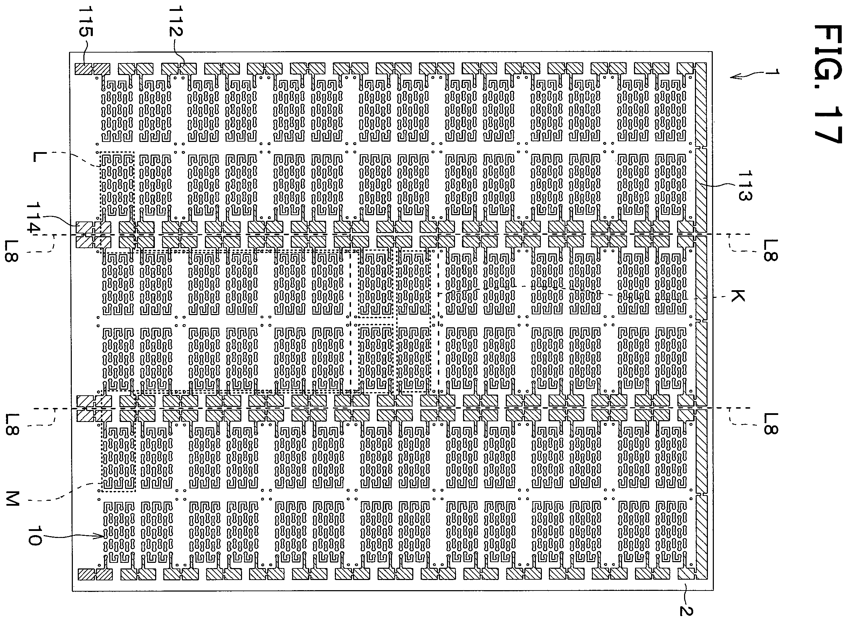

   Fig. 17 is an example of a cutting line L8 of the thermoelectric conversion element sheet 1 in a modified example of the second embodiment of the present disclosure;
[Fig. 18]

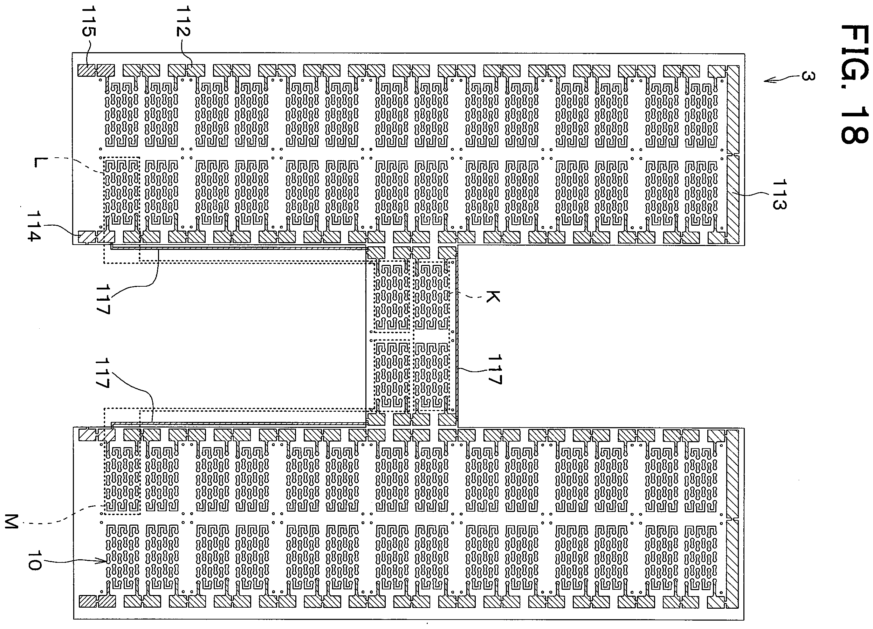

   Fig. 18 is a view showing the thermoelectric conversion device 3 obtained by cutting the thermoelectric conversion element sheet 1 along the cutting line L8 shown in Fig. 17;
[Fig. 19]

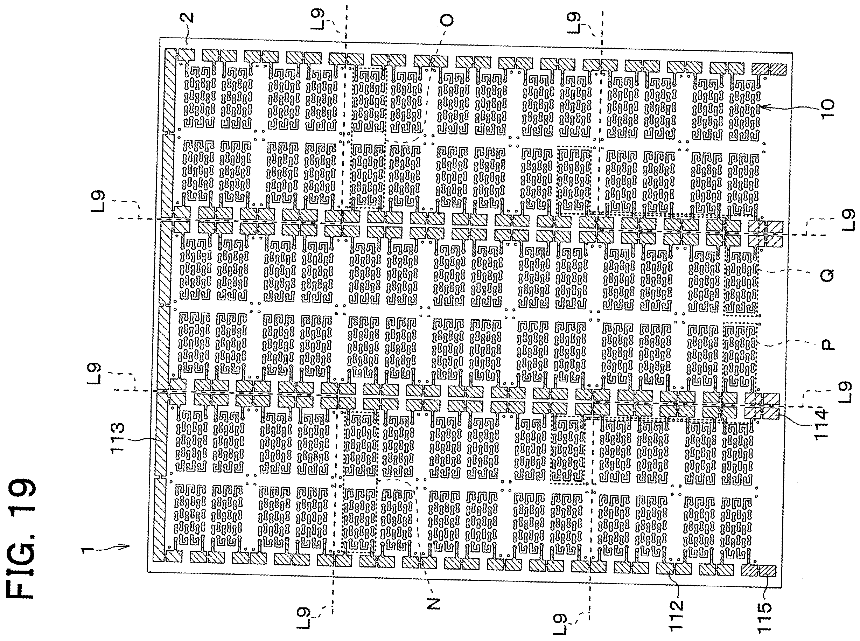

   Fig. 19 is an example of a cutting line L9 of the thermoelectric conversion element sheet 1 in a modified example of the second embodiment of the present disclosure;
[Fig. 20]

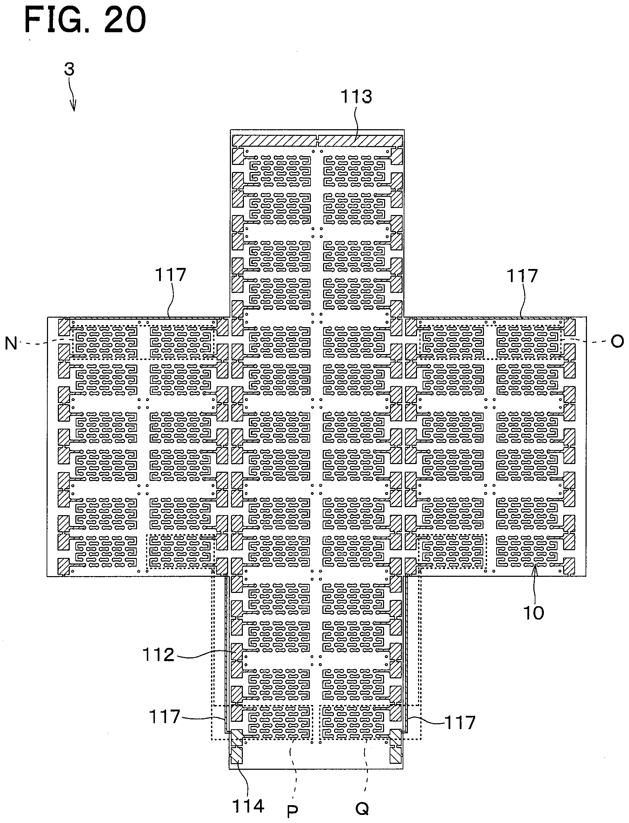

   Fig. 20 is a view showing the thermoelectric conversion device 3 obtained by cutting the thermoelectric conversion element sheet 1 along the cutting line L9 shown in Fig. 19;
[Fig. 21A]

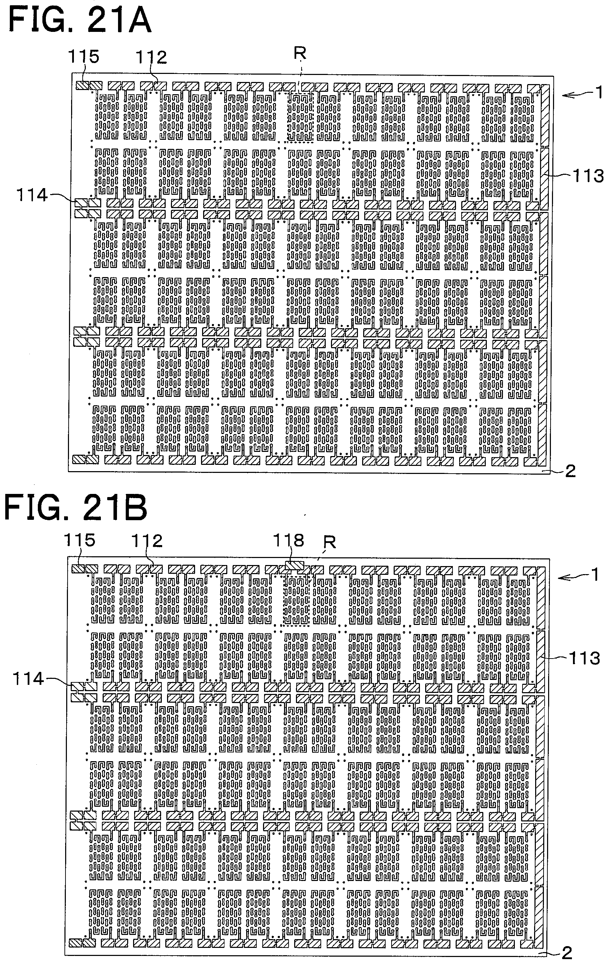

   Fig. 21A is a view showing a characteristic-defective place of a thermoelectric conversion element sheet 1 in a third embodiment of the present disclosure;
[Fig. 21B]
   Fig. 21B is a view showing each of the thermoelectric conversion elements 10 being connected in series except for the characteristic-defective place in the thermoelectric conversion element sheet 1;
[Fig. 22]

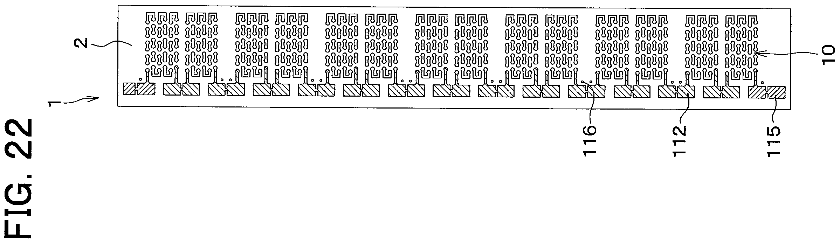

   Fig. 22 is a front surface view showing the thermoelectric conversion element sheet 1 in another embodiment of the disclosure; and
[Fig. 23]

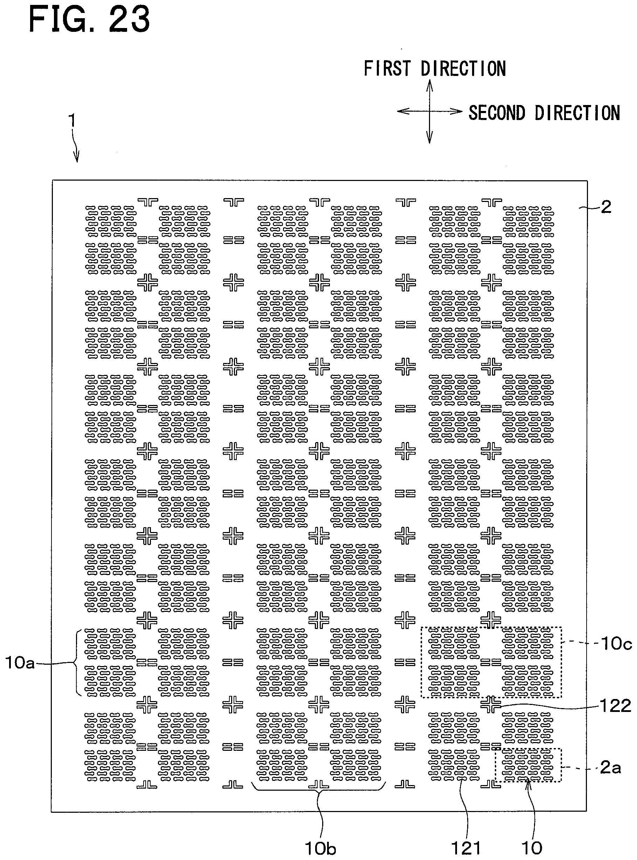

   Fig. 23 is a rear surface view showing the thermoelectric conversion element sheet 1 in another embodiment of the disclosure.

### EMBODIMENTS FOR CARRYING OUT INVENTION

Hereinafter, embodiments of the present disclosure will be described with reference to the drawings. In each of the following embodiments, a description will be given providing the same numerals to the same or equivalent portions.

### FIRST EMBODIMENT

A first embodiment of the present disclosure will be described with reference to the drawings. As shown in Figs. 1 and 2, the thermoelectric conversion element sheet 1 includes a base material 2 having a plurality of formation regions 2a, and thermoelectric conversion elements 10 are formed in the respective formation regions 2a.

Fig. 1 shows only one formation region as the formation region 2a. In Fig. 1, a front surface protection member 110 described later is omitted so as to facilitate understanding, and in Fig. 2, a rear surface protection member 120 described later is omitted so as to facilitate understanding.

In the present embodiment, it is assumed that the base material 2 (thermoelectric conversion element sheet 1) has a planar rectangular shape, and one direction is a longitudinal direction (a vertical direction in each of the paper of Figs. 1 and 2). When the longitudinal direction is defined as a first direction, and a planar direction of the base material 2 which is orthogonal to (intersects with) the first direction is defined as a second direction (a horizontal direction in each of the paper of Figs. 1 and 2), in the present embodiment, 14 thermoelectric conversion elements 10 are formed in the first direction and six thermoelectric conversion elements 10 are formed in the second direction. That is, in the present embodiment, 84 thermoelectric conversion elements 10 are formed in the thermoelectric conversion element sheet 1. In other words, 15 formation regions 2a are provided in the first direction while six formation regions 2a are provided in the second direction, totaling up to 84 formation regions.

Specifically, as for the thermoelectric conversion elements 10 of the present embodiment, when two thermoelectric conversion elements 10 adjacent in the first direction are taken as a first pair 10a, the first pair 10a is formed so as to be spaced from another first pair 10a by a predetermined distance in the first direction. Further, when two thermoelectric conversion elements 10 adjacent in the second direction are taken as a second pair 10b, the second pair 10b is formed so as to be spaced from another second pair 10b by a predetermined distance in the second direction. In other words, when the two second pairs 10b (four thermoelectric conversion elements 10) adjacent in the first direction are taken as a group 10c, the group 10c is formed so as to be spaced from another group 10c by respective predetermined distances in the first direction and the second direction.

Here, the configuration of each of the thermoelectric conversion elements 10 will be described with reference to Figs. 1 to 3. Each of the thermoelectric conversion elements 10 has a similar configuration and is configured such that the second direction is the longitudinal direction.

In the base material 2, the thermoelectric conversion element 10 is formed by alternately connecting first and second interlayer connection members 130, 140 in series, and the base material 2 includes an insulating base member 100, the front surface protection member 110, and the rear surface protection member 120.

In the present embodiment, the insulating base member 100 is formed of a thermoplastic resin film in a planar rectangular shape, represented by polyether ether ketone (PEEK), polyether imide (PEI), and liquid crystal polymer (LCP). Then, in each formation region 2a, a plurality of first and second via holes 101, 102 passing therethrough in the thickness direction are formed in a zigzag pattern so as to alternate with each other.

Although each of the first and second via holes 101, 102 of the present embodiment is assumed to have a diameter constant from the front surface 100a to the rear surface 100b, each of the first and second via holes 101, 102 may have a tapered shape with its diameter getting smaller from the front surface 100a to the rear surface 100b. Further, each of the first and second via holes 101, 102 may have a tapered shape with its diameter getting smaller from the rear surface 100b toward the front surface 100a, or may have a rectangular cylindrical shape.

The first interlayer connection member 130 is disposed in each first via hole 101, and the second interlayer connection member 140 is disposed in each second via hole 102. That is, in the insulating base member 100, the first and second interlayer connection members 130, 140 are disposed so as to alternate with each other in the formation region 2a.

Although not particularly restrictive, the first interlayer connection member 130 is, for example, made of a metal compound (sintered alloy) formed by subjecting Bi-Sb-Te alloy powder that constitutes the P-type to solid-phase sintering so as to keep a crystal structure of a plurality of metal atoms before the sintering. Further, the second interlayer connection member 140 is made of a metal compound (sintered alloy) formed by subjecting Bi-Te alloy powder that constitutes the N-type to solid-phase sintering so as to keep a predetermined crystal structure of a plurality of metal atoms before the sintering. As thus described, the metal compounds subjected to solid-phase sintering so as to keep the predetermined crystal structures are used as the first and second interlayer connection members 130, 140, thereby enabling an increase in electromotive force (voltage).

The front surface protection member 110 is formed of a thermoplastic resin film having a planar rectangular shape, represented by polyether ether ketone (PEEK), polyether imide (PEI), and liquid crystal polymer (LCP), and is disposed on the front surface 100a of the insulating base member 100. This front surface protection member 110 has the same planar shape as that of the insulating base member 100, and a plurality of front surface patterns 111 with copper foil or the like patterned on one surface 110a facing the insulating base member 100 are formed so as to be spaced from each other. Then, each of the front surface patterns 111 is appropriately electrically connected with the first and second interlayer connection members 130, 140 along with each of rear surface patterns 121 described later such that the first and second interlayer connection members 130, 140 are connected in series in the formation region 2a.

The rear surface protection member 120 is formed of a thermoplastic resin film having a planar rectangular shape, represented by polyether ether ketone (PEEK), polyether imide (PEI), and liquid crystal polymer (LCP), and disposed on the rear surface 100b of the insulating base member 100. This rear surface protection member 120 has the same planar shape as that of the insulating base member 100, and a plurality of rear surface patterns 121 with copper foil or the like patterned on one surface 120a facing the insulating base member 100 are formed so as to be spaced from each other. Then, the rear surface patterns 121 is appropriately electrically connected with the first and second interlayer connection members 130, 140 along with each of the front surface patterns 111 such that the first and second interlayer connection members 130, 140 are connected in series in the formation region 2a.

That is, it can also be said that the front surface patterns 111 and the rear surface patterns 121 are formed on the front surface protection member 110 and the rear surface protection member 120 such that the first and second interlayer connection members 130, 140 are alternately connected in series. In the present embodiment, as shown in Figs. 1 and 2, each of the thermoelectric conversion elements 10 has a configuration where the first and second interlayer connection members 130, 140 being alternately connected in series in the second direction are folded back a plurality of times in each formation region 2a.

What has been described above is the configuration of each of the thermoelectric conversion elements 10. As shown in Figs. 1 and 3, in the front surface protection member 110, each of the thermoelectric conversion elements 10 is electrically connected on the one surface 110a facing the insulating base member 100, and first to fourth connection patterns 112 to 115 obtained by patterning copper foil or the like are formed so as to be used as electrodes (patterns for extracting electrodes) that make electrical connection with an external circuit at the time of the cutting. In order to facilitate understanding of Fig. 1 though it is not a sectional view, each of the first to fourth connection patterns 112 to 115 is provided with different hatching.

The first connection patterns 112 are formed so as to be spaced from each other in the first direction. Two thermoelectric conversion elements 10 adjacent in the first direction are electrically connected to each other through the first connection pattern 112.

Further, the second connection patterns 113 are formed so as to be spaced from each other in the second direction on one end side in the first direction (on the upper side of the paper of Fig. 1). On the one end side in the first direction, the thermoelectric conversion elements 10 of the second group 10b are electrically connected to each other through the second connection pattern 113 in the second group 10b.

The third connection patterns 114 are formed so as to be spaced from each other in the second direction on the other end side in the first direction (on the lower side of the paper of Fig. 1). On the other end side in the first direction, in two second pairs 10b adjacent in the second direction, the thermoelectric conversion element 10 of one second pair 10b side in the other second group 10b is electrically connected with the thermoelectric conversion element 10 on the other second pair 10b side in the one second group 10b.

Accordingly, when the thermoelectric conversion element 10 on the lower left side of the paper of Fig. 1 is taken as a start of the thermoelectric conversion element sheet 1, as indicated by an arrow A in Fig. 4, the thermoelectric conversion elements 10 are sequentially connected to each other in series from this thermoelectric conversion element 10 on the lower left side toward the thermoelectric conversion element 10 on the lower right side of the paper of Fig. 1.

Connection structure of the thermoelectric conversion elements 10 and each of the connection patterns 112 to 114 will be described here. In each thermoelectric conversion element 10, the first and second interlayer connection members 130, 140 are connected in series alternately through the front surface pattern 111 and the rear surface pattern 121, but the first interlayer connection member 130 or the second interlayer connection member 140 at both ends in an electrically serially connected direction is not connected with the front surface pattern 111. Therefore, the first interlayer connection member 130 on one end side in the serially connected direction in one thermoelectric conversion element 10 and the second interlayer connection member 140 on the other end side in the serially connected direction in the other thermoelectric conversion elements 10 are electrically connected through the first connection pattern 112, the second connection pattern 113, or the third connection pattern 114.

Further, on the thermoelectric conversion element sheet 1 as thus described, as for the thermoelectric conversion elements 10 at both ends in the serially connected direction (the thermoelectric conversion elements 10 on the lower left and the lower right of the paper of Fig. 1), the first interlayer connection member 130 or the second interlayer connection member 140 at one end in the serially connected direction in the thermoelectric conversion element 10 is connected with neither the front surface pattern 111 nor the first connection pattern 112. Accordingly, the fourth connection pattern 115 is formed so as to be electrically connected with the first interlayer connection member 130 or the second interlayer connection member 140 electrically connected with neither the front surface pattern 111 nor the first connection pattern 112.

In the present embodiment, for facilitating to cut the first to fourth connection patterns 112 to 115 at the time of cutting the thermoelectric conversion element sheet 1 described later, an intermediate portion (a portion that may be cut) of each of the first to fourth connection patterns 112 to 115 is made thinner than the other portion of the first to fourth connection patterns 112 to 115.

Further, in the present embodiment, as shown in Fig. 1, a plurality of alignment marks 116 are formed on the one surface 110a of the front surface protection members 110, the one surface 110a facing the insulating base member 100. Similarly, as shown in Fig. 2, a plurality of alignment marks 122 are formed on the one surface 120a of the rear surface protection members 120, the one surface 120a facing the insulating base member 100. In the present embodiment, each of the alignment marks 116, 122 has a dot shape appropriately formed between the groups 10c, and is configured by patterning copper foil or the like.

What has been described above is the configuration of the thermoelectric conversion element sheet 1 in the present embodiment. Next, a method for manufacturing the thermoelectric conversion element sheet 1 as above will be described with reference to Figs. 5A to 5H. Figs. 5A to 5H are sectional views showing a manufacturing process of a portion corresponding to Fig. 3, and a similar process is also performed in the other formation regions 2a.

First, as shown in Fig. 5A, an insulating base member 100 having the front surface 100a and the rear surface 100b is prepared, and a plurality of first via holes 101 are formed in each formation region 2a of the insulating base member 100 by use of a drill, a laser, or the like. Note that the range of each formation region 2a of the insulating base member 100 matches the range of each formation region 2a of the base material 2.

Next, as shown in FIG. 5B, each first via hole 101 is filled with a first conductive paste 131. As a method (device) for filling the first via hole 101 with the first conductive paste 131, a method (device) described in JP-2010-50356-A applied by the present applicant may be employed.

Briefly describing, the insulating base member 100 is disposed on a holding stand, not shown, through adsorbent paper 150 such that the rear surface 100b faces the adsorbent paper 150. Then, the first via hole 101 is filled with the first conductive paste 131 while the first conductive paste 131 is melt. Thereby, most of an organic solvent of the first conductive paste 131 is adsorbed by the adsorbent paper 150, and the alloy powder is disposed in close contact with the first via hole 101.

The adsorbent paper 150 may be any material so long as being able to absorb the organic solvent of the first conductive paste 131, and general high-quality paper or the like is used. Further, as the first conductive paste 131, there is used a paste-like material obtained by adding an organic solvent such as paraffin with a melting point of 43°C to Bi-Sb-Te alloy powder to form a paste, the powder having metal atoms that keep a predetermined crystal structure. Thus, the filling the via hole with the first conductive paste 131 is performed in a state where the front surface 100a of the insulating base member 100 has been heated to about 43°C.

Subsequently as shown in Fig. 5C, a plurality of second via holes 102 are formed in each formation region 2a of the insulating base member 100 by use of the drill, the laser, or the like. This second via holes 102 are formed so as to alternate with the first via holes 101 and configures a zigzag pattern along with the first via holes 101 as described above.

Next, as shown in FIG. 5D, each second via hole 102 is filled with a second conductive paste 141. This step can be performed by a similar step to that of Fig. 5B.

That is, again, the insulating base member 100 is disposed on the holding stand, not shown, through the adsorbent paper 150 such that the rear surface 100b faces the adsorbent paper 150, and thereafter, the second via hole 102 is filled with the second conductive paste 141. Thereby, most of an organic solvent of the second conductive paste 141 is adsorbed to the adsorbent paper 150, and alloy powder is disposed in close contact with the second via hole 102.

As the second conductive paste 141, there is used a paste-like material obtained by adding an organic solvent such as teripineol with a melting point of a normal temperature to Bi-Te alloy powder to form a paste, the powder having metal atoms which are different from the metal atoms constituting the first conductive paste 131, and keeping a predetermined crystal structure. That is, as the organic solvent to constitute the second conductive paste 141, there is used an organic solvent with a melting point lower than that of the organic solvent constituting the first conductive paste 131. The filling the via hole with the second conductive paste 141 is performed in a state where the front surface 100a of the insulating base member 100 is kept at the normal temperature. In other words, the filling the via hole with the second conductive paste 141 is performed in a state where the organic solvent contained in the first conductive paste 131 is solidified. This prevents the second conductive paste 141 from being mixed into the first via hole 101.

The state where the organic solvent contained in the first conductive paste 131 is solidified means a state where the organic solvent, not adsorbed to the adsorbent paper 150 in the above step of Fig. 5B and remaining in the first via hole 101, is solidified.

Next, in a different step from each of the above steps, as shown in Fig. 5E, the front surface protection member 110 is prepared. Of this front surface protection member 110, the one surface 110a facing the insulating base member 100 is formed with copper foil or the like. Then, this copper foil is appropriately patterned, to form a plurality of front surface patterns 111 spaced from each other and the first connection patterns 112. Further, in a different cross section of FIG. 5E, the second connection pattern 113, the third connection pattern 114, the fourth connection pattern 115, and the alignment marks 116 are formed. That is, the front surface patterns 111, the first to fourth connection patterns 112 to 115, and the alignment mark 116 are formed in the same step.

Similarly, as shown in Fig. 5F, the rear surface protection member 120 is prepared. Of this rear surface protection member 120, the one surface 120a facing the insulating base member 100 is formed with copper foil or the like. Then, this copper foil is appropriately patterned, to form a plurality of rear surface patterns 121 spaced from each other. Further, the alignment mark 122 is formed on a cross section different from Fig. 5F. That is, the rear surface pattern 121 and the alignment marks 122 are formed in the same step.

Thereafter, as shown in Fig. 5G, the rear surface protection member 120, the insulating base member 100, and the front surface protection member 110 are sequentially stacked, to form a stacked body 160. At this time, the stacked body 160 is formed such that the first conductive paste 131 and the second conductive paste 141 appropriately come into contact with the front surface pattern 111 and the rear surface pattern 121.

Subsequently, as shown in Fig. 5H, this stacked body 160 is disposed between a pair of pressing plates, not shown. Then, the stacked body 160 is integrated by being pressed from both upper and lower surfaces in a stacking direction in a vacuum state while being heated, to thereby constitute the thermoelectric conversion element sheet 1 provided with the base material 2. Specifically, the first and second conductive pastes 131, 141 is subjected to solid-phase sintering to form the first and second interlayer connection members 130, 140, and the stacked body 160 is integrated by being pressed while heated such that the first and second interlayer connection members 130, 140 appropriately come into contact with the front surface pattern 111, the rear surface pattern 121, and the first to fourth connection patterns 112 to 115. Although not being particularly restrictive, a buffer such as rock wool paper may be disposed between the stacked body 160 and the pressing plate at the time of integrating the stacked body 160.

What has been described above is the method for manufacturing the thermoelectric conversion element sheet 1 in the present embodiment. By appropriately cutting the thermoelectric conversion element sheet 1 as thus described, it is possible to obtain a thermoelectric conversion device with desired conversion efficiency (a desired number of thermoelectric conversion elements 10). Specifically, by cutting the thermoelectric conversion element sheet 1 such that the first to fourth connection patterns 112 to 115 are appropriately divided, it is possible to obtain the thermoelectric conversion device. At the time of cutting the thermoelectric conversion element sheet 1, the cutting can be facilitated by cutting an intermediate portion of each of the first to fourth connection patterns 112 to 115 (a thinned portion of each of the first to fourth connection patterns 112 to 115).

For example, by cutting the thermoelectric conversion element sheet 1 along cutting lines L0 of Fig. 6, a thermoelectric conversion device 3 having one thermoelectric conversion element 10 can be obtained as shown in Fig. 8A.

Further, by cutting the thermoelectric conversion element sheet 1 along a cutting line L1 in Fig. 7, 14 thermoelectric conversion elements 10 are formed in the first direction as shown in Fig. 8B, and it is possible to obtain the thermoelectric conversion device 3 with each of the thermoelectric conversion elements 10 connected in series.

By cutting the thermoelectric conversion element sheet 1 along a cutting line L2 in Fig. 7, two thermoelectric conversion elements 10 each are formed in the first direction and the second direction as shown in Fig. 8C, and it is possible to obtain the thermoelectric conversion device 3 with each of the thermoelectric conversion elements 10 connected in series. In this thermoelectric conversion device 3, the thermoelectric conversion elements 10 formed in the second direction are electrically connected by the second connection pattern 113.

Further, by cutting the thermoelectric conversion element sheet 1 along a cutting line L3 in Fig. 7, two thermoelectric conversion elements 10 each are formed in the first direction and the second direction as shown in Fig. 8D, and it is possible to obtain the thermoelectric conversion device 3 with each of the thermoelectric conversion elements 10 connected in series. In this thermoelectric conversion device 3, the thermoelectric conversion elements 10 formed in the second direction is electrically connected by the third connection pattern 114.

That is, as shown in Figs. 8C and 8D, when the thermoelectric conversion element sheet 1 is to be cut to obtain the thermoelectric conversion device 3 having two thermoelectric conversion elements 10 in the second direction, the thermoelectric conversion element sheet 1 may be cut so as to include the second connection pattern 113 or the third connection pattern 114. By performing the cutting in this manner, it is possible to obtain the thermoelectric conversion device 3 with each of the thermoelectric conversion elements 10 connected in series.

In order to facilitate understanding of Figs. 6 to 8D though they are not sectional views, the first to fourth connection patterns 112 to 115 are provided with hatching. Further, when the thermoelectric conversion element sheet 1 is to be cut, the alignment marks 116, 122 formed on the front surface protection member 110 and the rear surface protection member 120 are appropriately used and the cutting is performed using the laser or the like.

Then, in the thermoelectric conversion device 3 obtained by cutting the thermoelectric conversion element sheet 1, a hole is formed in the front surface protection member 110 by use of the laser or the like so as to make exposed a part of each of the first to fourth connection patterns 112 to 115 connected only with the thermoelectric conversion elements 10 at both ends in the electrically serially connected direction. That is, for example, in the thermoelectric conversion device 3 of Fig. 8A, the hole is formed such that a part of the two divided first connection patterns 112 is exposed. Hence the two divided first connection patterns 112 can be used as they are as electrodes to be electrically connected with the external circuit.

Although the method for obtaining the thermoelectric conversion device 3 by cutting the thermoelectric conversion element sheet 1 has been described here, the thermoelectric conversion element sheet 1 may be used as it is.

As described above, in the present embodiment, the thermoelectric conversion elements 10 are formed in the respective formation regions 2a, and each of the thermoelectric conversion elements 10 is connected in series. Hence a position at which the thermoelectric conversion element sheet 1 is cut may be changed depending on the intended use, and the design of the thermoelectric conversion element sheet 1 need not be changed. It is thus possible to improve the degree of freedom for design and manufacturing.

Further, the cutting is performed such that the first to fourth connection patterns 112 to 115 are appropriately cut. Hence each of the first to fourth connection patterns 112 to 115 can be used as it is as an electrode to be electrically connected with the external circuit, thus simplifying the manufacturing process.

### SECOND EMBODIMENT

A second embodiment of the present disclosure will be described. According to the present embodiment, in relation to the first embodiment, the cutting lines of the thermoelectric conversion element sheet 1 are changed. Other elements of the present embodiment are similar to those of the first embodiment, and hence a description thereof will be omitted here.

In the present embodiment, the thermoelectric conversion element sheet 1 is cut such that a part of the adjacent thermoelectric conversion elements 10 comes into an electrically unconnected state (electrical connection thereof is divided), and thereafter, the electrically unconnected thermoelectric conversion elements 10 are electrically connected with each other, to thereby connect each of the thermoelectric conversion elements 10 in series.

Specifically, in the present embodiment, the thermoelectric conversion element sheet 1 is cut along the cutting line L4 in Fig. 9 (see Fig. 10). In this case, in a state after the cutting, two thermoelectric conversion elements 10 in a region B in Fig. 9 are not electrically connected. Hence, as shown in Fig. 10, after the cutting of the thermoelectric conversion element sheet 1, the two thermoelectric conversion elements 10 in the region B are electrically connected by rear connection wiring 117. It is thereby possible to obtain the thermoelectric conversion device 3 with 60 thermoelectric conversion elements 10 connected in series and its planar shape being a substantially U shape.

As the rear connecting wiring 117, plating wiring, printing wiring, lead wiring, or the like is used. For example, after a hole is formed in the front surface protection member 110 by the laser or the like such that a part of the two first connection patterns 112 connected only with one thermoelectric conversion element 10 in the region B is exposed, the rear connection wiring 117 is formed so as to electrically connect these two first connection patterns 112.

As described above, after the thermoelectric conversion element sheet 1 is cut such that a part of the adjacent thermoelectric conversion elements 10 comes into an electrically unconnected state, the electrically non-connected thermoelectric conversion elements 10 may be electrically connected by the rear connection wiring 117, to thereby obtain the thermoelectric conversion device 3 with each of the thermoelectric conversion elements 10 connected in series. With this configuration, the cutting line used at the time of cutting the thermoelectric conversion element sheet 1 can be designed more freely, thereby improving the degree of freedom for design and manufacturing.

### MODIFICATION OF SECOND EMBODIMENT

Although the example of cutting the thermoelectric conversion element sheet 1 along the cutting line L4 has been described in the above second embodiment, the cutting line can be appropriately changed, which will be described below by giving several examples. In order to facilitate understanding of each of the drawings described below though they are not sectional views, the first to fourth connection patterns 112 to 115 and the rear connection wiring 117 are provided with hatching.

For example, as shown in Fig. 11, the thermoelectric conversion element sheet 1 may be cut along a cutting line L5 (see Fig. 12). In this case, in a state after the cutting, two thermoelectric conversion elements 10 in each of a region C and a region D in Fig. 11 are not electrically connected. Hence, as shown in Fig. 12, after the cutting of the thermoelectric conversion element sheet 1, the two thermoelectric conversion elements 10 in each of the region C and the region D are electrically connected by the rear connection wiring 117. It is thereby possible to obtain the thermoelectric conversion device 3 with 44 thermoelectric conversion elements 10 connected in series and its planar shape being a substantially L shape.

Further, as shown in Fig. 13, the thermoelectric conversion element sheet 1 may be cut along a cutting line L6 (see Fig. 14). In this case, in a state after the cutting, two thermoelectric conversion elements 10 in each of a region E and a region F in Fig. 13 are not electrically connected. Hence, as shown in Fig. 14, after the cutting of the thermoelectric conversion element sheet 1, the two thermoelectric conversion elements 10 in each of the region E and the region F are electrically connected by the rear connection wiring 117. It is thereby possible to obtain the thermoelectric conversion device 3 with 72 thermoelectric conversion elements 10 connected in series and its planar shape being a substantially O shape.

Further, as shown in Fig. 15, the thermoelectric conversion element sheet 1 may be cut along a cutting line L7 (see Fig. 16). In this case, in a state after the cutting, two thermoelectric conversion elements 10 in each of a region G, a region H, a region I, and a region J in Fig. 16 are not electrically connected. Hence, as shown in Fig. 16, after the cutting of the thermoelectric conversion element sheet 1, the two thermoelectric conversion elements 10 in each of the region G, the region H, the region I, and the region J are electrically connected by the rear connection wiring 117. It is thereby possible to obtain the thermoelectric conversion device 3 with 44 thermoelectric conversion elements 10 connected in series.

Further, as shown in Fig. 17, the thermoelectric conversion element sheet 1 may be cut along a cutting line L8 (see Fig. 18). In this case, in a state after the cutting, two thermoelectric conversion elements 10 in each of a region K, a region L, and a region M in Fig. 17 are not electrically connected. Hence, as shown in Fig. 18, after the cutting of the thermoelectric conversion element sheet 1, the two thermoelectric conversion elements 10 in each of the region K, the region L, and the region M are electrically connected by the rear connection wiring 117. It is thereby possible to obtain the thermoelectric conversion device 3 with 60 thermoelectric conversion elements 10 connected in series and its planar shape being a substantially H shape.

As shown in Fig. 19, the thermoelectric conversion element sheet 1 may be cut along a cutting line L9 (see Fig. 20). In this case, in a state after the cutting, two thermoelectric conversion elements 10 in each of a region N, a region O, a region P, and a region Q in Fig. 19 are not electrically connected. Hence, as shown in Fig. 20, after the cutting of the thermoelectric conversion element sheet 1, the two thermoelectric conversion elements 10 in each of the region N, the region O, the region P, and the region Q are electrically connected by the rear connection wiring 117. It is thereby possible to obtain the thermoelectric conversion device 3 with 52 thermoelectric conversion elements 10 connected in series and its planar shape being a substantially "+" (plus) shape.

As described above, even when the thermoelectric conversion element sheet 1 is cut, a similar effect to that of the above second embodiment can be obtained by appropriately electrically connecting the thermoelectric conversion elements 10 with each other by use of the rear connection wiring 117 after the cutting.

### THIRD EMBODIMENT

A third embodiment of the present disclosure will be described. According to the present embodiment, in relation to the first embodiment, an inspection step is performed after the manufacturing of the thermoelectric conversion element sheet 1. Other respects of the present embodiment are similar to those of the first embodiment, and hence a description thereof will be omitted here.

In the present embodiment, characteristic inspection of the thermoelectric conversion element 10 is performed after the manufacturing of the thermoelectric conversion element sheet 1. Specifically, the two fourth connection patterns 115 on the lower left and the lower right of the paper of Fig. 1 are connected with the external circuit, to thereby perform entire characteristic inspection. When the result of the entire characteristic inspection is a characteristic defect (when the entire electromotive force does not satisfy reference electric power and is not normal), each thermoelectric conversion element 10 is individually subjected to the characteristic inspection, to thereby specify a characteristic-defective place of the thermoelectric conversion element 10.

When the entire characteristic inspection is to be performed, a hole is formed such that a part of the two fourth connection patterns 115 is exposed, and the fourth connection patterns 115 and the external circuit are electrically connected through the hole. Further, when the characteristic inspection of each thermoelectric conversion elements 10 is to be individually performed, a hole is formed such that a part of each of the connection patterns 112 to 114 connected with each thermoelectric conversion element 10 is exposed, and each of the connection patterns 112 to 115 and the external circuit are electrically connected through the hole. That is, in the present embodiment, when the entire characteristic inspection is normal, the hole which makes the part of each of the first to third connection patterns 112 to 115 exposed is not formed, to prevent a foreign matter from adhering to each of the first to third connection patterns 112 to 114 through the hole.

Then, for example as shown in Fig. 21A, when the thermoelectric conversion element 10 in the region R is characteristic-defective (not normal), as shown in Fig. 21B, two thermoelectric conversion elements 10, sandwiching the thermoelectric conversion element 10 in the region R and adjacent to this thermoelectric conversion element, are electrically connected with each other through front connection wiring 118 to thereby connect the other thermoelectric conversion elements 10 in series except for the characteristic-defective thermoelectric conversion element 10. Accordingly, even when a characteristic-defective thermoelectric conversion element 10 is present in the thermoelectric conversion element sheet 1, it is possible to use the thermoelectric conversion element sheet 1 as it is.

When the thermoelectric conversion element sheet 1 is to be cut to obtain the thermoelectric conversion device 3, it is possible to obtain the thermoelectric conversion device 3 with desired conversion efficiency by performing the cutting in consideration of the characteristic-defective thermoelectric conversion element 10.

As described above, in the present embodiment, the characteristic inspection is performed, and when the thermoelectric conversion element 10 is characteristic-defective, two thermoelectric conversion elements 10, sandwiching the characteristic-defective thermoelectric conversion element 10 and adjacent to this thermoelectric conversion element, are electrically connected with each other through the front connection wiring 118. Accordingly, even when a characteristic-defective thermoelectric conversion element 10 is present in the thermoelectric conversion element sheet 1, it is possible to use the thermoelectric conversion element sheet 1 as it is.

### OTHER EMBODIMENTS

In each of the above embodiments, for example, the base material 2 (thermoelectric conversion element sheet 1) may not be formed in a planar rectangular shape, but may be formed in a planar square shape with the same lengths in the first direction and the second direction, for example. Further, the base material 2 (thermoelectric conversion element sheet 1) may have a parallelogram shape. That is, the first direction and the second direction may not be orthogonal to each other.

Similarly, in each of the above embodiments, the thermoelectric conversion element 10 may not have the longitudinal direction in the second direction, but may have the longitudinal direction in the first direction.

Further, in each of the above embodiments, the examples have been described where the thermoelectric conversion element sheet 1 is cut to obtain the thermoelectric conversion device 3 with desired conversion efficiency, but the thermoelectric conversion device 3 with desired thermoelectric conversion efficiency may be obtained at the time of manufacturing the thermoelectric conversion element sheet 1. That is, for example at the time of manufacturing the thermoelectric conversion element sheet 1, it is formed into the shape of Fig. 10, and the thermoelectric conversion element sheet 1 may be used as it is as the thermoelectric conversion device 3.

Moreover, as a modified example of each of the above embodiments, as shown in Fig. 22, there may be obtained the thermoelectric conversion element sheet 1 with the thermoelectric conversion elements 10 formed only in the first direction. In order to facilitate understanding of Fig. 22 though it is not a sectional view, each of the first and fourth connection patterns 112, 115 is provided with hatching.

Then, in each of the above embodiments, the alignment marks 116 may be formed only in the front surface protection member 110, or the alignment marks 122 may be formed only in the rear surface protection member 120. Further, each of the alignment marks 116, 122 may not be formed between each of the groups 10c, but be formed between each of the thermoelectric conversion elements 10. Further, each of the alignment marks 116, 122 may not have a dot shape, but for example, as shown in Fig. 23, a portion surrounded by the alignment marks 122 may have a substantially cross shape or a linear shape. Then, the alignment marks 116, 122 may not be formed.

Further, in each of the above embodiments, at the time of cutting the thermoelectric conversion element sheet 1, a dicing cutter or the like may be used instead of the laser.

Further, in each of the above embodiments, the example has been described where, in the thermoelectric conversion device 3 obtained by cutting the thermoelectric conversion element sheet 1, the hole is formed in the front surface protection member 110 so as to make exposed the part of each of the first to fourth connection patterns 112 to 115 connected only with the thermoelectric conversion elements 10 at both ends in the serially connected direction. However, the hole which makes the part of each of the first to fourth connection patterns 112 to 115 exposed may be formed before the thermoelectric conversion element sheet 1 is cut. In this case, in the state of the thermoelectric conversion element sheet 1, the hole may be formed in advance only in a portion to be a target. Further, a hole may be formed so as to make all of the first to fourth connection patterns 112 to 115 exposed, and after the thermoelectric conversion element sheet 1 is cut to obtain the thermoelectric conversion device 3, the hole in a portion not connected with the external circuit may be sealed.

## Claims

1. A method for manufacturing a thermoelectric conversion element sheet, the method comprising:
preparing an insulating base member (100) that includes a plurality of formation regions (2a), and has thermoplastic resin in which a plurality of first via holes and a plurality of second via holes (101, 102) penetrating the formation regions in a thickness direction are arranged in each of the plurality of formation regions, and the first via holes and the second via holes are respectively filled with a first conductive paste and a second conductive paste (131, 141);
preparing a front surface protection member (110) having a plurality of front surface patterns (111) spaced apart from each other and a plurality of connection patterns (112 to 115) spaced apart from each other, which are arranged on one surface (110a) of the front surface protection member;
preparing a rear surface protection member (120) having a plurality of rear surface patterns (121) spaced apart from each other, which are arranged on one surface (120a) of the rear surface protection member;
arranging the front surface protection member on a front surface of the insulating base member to contact the first conductive paste and the second conductive paste with the front surface patterns and the connection patterns, respectively, and arranging the rear surface protection member on a rear surface of the insulating base member to contact the first conductive paste and the second conductive paste with the rear surface patterns, respectively, so as to form a stacked body (160); and
heating and pressing the stacked body in a stacking direction to integrate into one body so that a first interlayer connection member and a second interlayer connection member (130, 140) are formed from the first conductive paste and the second conductive paste in the each of the formation regions; connecting the first interlayer connection member and the second interlayer connection member with the front surface pattern and the rear surface pattern so as to alternately connect the first interlayer connection member and the second interlayer connection member in series with each other so that a thermoelectric conversion element (10) is formed; and electrically connecting adjacent thermoelectric conversion elements through the connection pattern so that thermoelectric conversion elements are connected in series with each other by connecting the adjacent thermoelectric conversion elements formed in a corresponding formation region; and
performing an entire characteristic inspection of the thermoelectric conversion elements connected in series with each other after integration of the stacked body, wherein:
in the entire characteristic inspection,
when the thermoelectric conversion elements connected in series with each other are not normal as a whole, the characteristic inspection is individually performed on each of the thermoelectric conversion elements, and
after performance of an individual characteristic inspection, two thermoelectric conversion elements adjacent to the thermoelectric conversion element being not normal are electrically connected through a connection wiring (118) so that other thermoelectric conversion elements except for the thermoelectric conversion element being not normal are electrically connected in series with each other.

## Patentansprüche

1. Verfahren zum Herstellen eines thermoelektrischen Konversionselementblechs, wobei das Verfahren aufweist:
Vorbereiten eines isolierenden Basiselements (100), das eine Mehrzahl an Ausbildungsbereichen (2a) beinhaltet und ein thermoplastisches Harz aufweist, in dem eine Mehrzahl an ersten Durchgangslöchern und eine Mehrzahl an zweiten Durchgangslöchern (101, 102), die die Ausbildungsbereiche in einer Dickenrichtung penetrieren, in jedem der Mehrzahl an Ausbildungsbereichen angeordnet sind, und wobei die ersten Durchgangslöcher und die zweiten Durchgangslöcher jeweils mit einer ersten Leitpaste und einer zweiten Leitpaste (131, 141) gefüllt sind;
Vorbereiten eines vorderen Oberflächenschutzelements (110) mit einer Mehrzahl an vorderen Oberflächenmustern (111), die voneinander beabstandet sind, und einer Mehrzahl an Verbindungsmustern (112 bis 115), die voneinander beabstandet sind, die auf einer Oberfläche (110a) des vorderen Oberflächenschutzelements angeordnet sind;
Vorbereiten eines hinteren Oberflächenschutzelements (120) mit einer Mehrzahl an hinteren Oberflächenmustern (121), die voneinander beabstandet sind und die auf einer Oberfläche (120a) des hinteren Oberflächenschutzelements angeordnet sind;
Anordnen des vorderen Oberflächenschutzelements an einer vorderen Oberfläche des isolierenden Basiselements, um die erste Leitpaste und die zweite Leitpaste mit den vorderen Oberflächenmustern und den Verbindungsmustern in Kontakt zu bringen, und Anordnen des hinteren Oberflächenschutzelements an einer hinteren Oberfläche des isolierenden Basiselements, um die erste Leitpaste und die zweite Leitpaste mit den hinteren Oberflächenmustern in Kontakt zu bringen, um einen Stapelkörper (160) auszubilden; und
Erwärmen und Pressen des Stapelkörpers in einer Stapelrichtung, um ihn in einen Körper zu integrieren, so dass ein erstes Zwischenschichtverbindungselement und ein zweites Zwischenschichtverbindungselement (130, 140) aus der ersten Leitpaste und der zweiten Leitpaste in jedem der Ausbildungsbereiche ausgebildet werden; Verbinden des ersten Zwischenschichtverbindungselements und des zweiten Zwischenschichtverbindungselements mit dem vorderen Oberflächenmuster und dem hinteren Oberflächenmuster, um abwechselnd das erste Zwischenschichtverbindungselement und das zweite Zwischenschichtverbindungselement in Reihe miteinander zu verbinden, so dass ein thermoelektrisches Konversionselement (10) ausgebildet wird; und elektrisches Verbinden benachbarter thermoelektrischer Konversionselemente durch das Verbindungsmuster, so dass thermoelektrische Konversionselemente miteinander in Reihe verbunden werden, indem die benachbarten thermoelektrischen Konversionselemente, die in einem entsprechenden Ausbildungsbereich ausgebildet sind, verbunden werden; und
Durchführen einer Gesamtkennlinieninspektion der thermoelektrischen Konversionselemente, die miteinander in Reihe verbunden sind, nach der Integration des Stapelkörpers, wobei:
bei der Gesamtkennlinieninspektion,
wenn die thermoelektrischen Konversionselemente, die in Reihe miteinander verbunden sind, in ihrer Gesamtheit nicht normal sind, die Kennlinieninspektion individuell bei jedem der thermoelektrischen Konversionselemente durchgeführt wird, und
nach der Durchführung einer individuellen Kennlinieninspektion zwei thermoelektrische Konversionselemente, die zu dem thermoelektrischen Konversionselement benachbart sind und nicht normal sind, durch eine Verbindungsverdrahtung (118) elektrisch verbunden werden, so dass andere thermoelektrische Konversionselemente mit Ausnahme des thermoelektrischen Konversionselements, das nicht normal ist, miteinander in Reihe elektrisch verbunden sind.

## Revendications

1. Procédé pour fabriquer une feuille d'élément de conversion thermoélectrique, le procédé comprenant les étapes suivantes :
préparer un élément de base isolant (100) qui comprend une pluralité de régions de formation (2a), et comporte de la résine thermoplastique dans laquelle une pluralité de premiers trous d'interconnexion et une pluralité de seconds trous d'interconnexion (101, 102) pénétrant dans les régions de formation dans le sens de l'épaisseur sont agencés dans chacune de la pluralité de régions de formation, et les premiers trous d'interconnexion et les seconds trous d'interconnexion sont respectivement remplis avec une première pâte conductrice et une seconde pâte conductrice (131, 141) ;
préparer un élément de protection de surface avant (110) ayant une pluralité de motifs de surface avant (111) espacés les uns des autres et une pluralité de motifs de raccordement (112 à 115) espacés les uns des autres, qui sont agencés sur une surface (110a) de l'élément de protection de surface avant ;
préparer un élément de protection de surface arrière (120) ayant une pluralité de motifs de surface arrière (121) espacés les uns des autres, qui sont agencés sur une surface (120a) de l'élément de protection de surface arrière ;
agencer l'élément de protection de surface avant sur une surface avant de l'élément de base isolant pour mettre en contact la première pâte conductrice et la seconde pâte conductrice avec les motifs de surface avant et les motifs de raccordement, respectivement, et agencer l'élément de protection de surface arrière sur une surface arrière de l'élément de base isolant pour mettre en contact la première pâte conductrice et la seconde pâte conductrice avec les motifs de surface arrière, respectivement, afin de former un corps empilé (160) ; et
chauffer et comprimer le corps empilé dans une direction d'empilement pour s'intégrer en un corps de sorte qu'un premier élément de connexion entre couches et un second élément de connexion entre couches (130, 140) sont formés à partir de la première pâte conductrice et de la seconde pâte conductrice dans chacune des régions de formation ; raccorder le premier élément de connexion entre couches et le second élément de connexion entre couches avec le motif de surface avant et le motif de surface arrière afin de raccorder, de manière alternée, le premier élément de connexion entre couches et le second élément entre couches en série l'un par rapport à l'autre de sorte qu'un élément de conversion thermoélectrique (10) est formé ; et raccorder électriquement des éléments de conversion thermoélectriques adjacents par le biais du motif de raccordement de sorte que les éléments de conversion thermoélectrique sont raccordés en série l'un par rapport à l'autre en raccordant les éléments de conversion thermoélectriques adjacents formés dans une région de formation correspondante ; et
réaliser un contrôle de caractéristique total des éléments de conversion thermoélectriques raccordés en série l'un par rapport à l'autre après l'intégration du corps empilé, dans lequel :
dans le contrôle de caractéristique total,
lorsque les éléments de conversion thermoélectriques raccordés en série l'un par rapport à l'autre ne sont pas normaux dans leur ensemble, le contrôle de caractéristique est réalisé individuellement sur chacun des éléments de conversion thermoélectriques, et
après la réalisation d'un contrôle de caractéristique individuel, deux éléments de conversion thermoélectriques adjacents à l'élément de conversion thermoélectrique qui ne sont pas normaux, sont électriquement raccordés par le biais d'un câblage de raccordement (118) de sorte que les autres éléments de conversion thermoélectriques, excepté l'élément de conversion thermoélectrique qui n'est pas normal, sont électriquement raccordés en série entre eux.
